Europäisches Patentamt

European Patent Office

Office européen des brevets

(19)

(11) Publication number: **0 166 705**
A2

## EUROPEAN PATENT APPLICATION

(21) Application number: 85850188.5

(22) Date of filing: 30.05.85

(51) Int. Cl.⁴: **G 01 R 27/26**

(30) Priority: 31.05.84 FI 842191
08.03.85 FI 850935

(43) Date of publication of application: 02.01.86
Bulletin 86/1

(84) Designated Contracting States: **CH DE FR GB IT LI NL SE**

(71) Applicant: **VAISALA OY, Vanha Nurmijärventie 21, SF-00420 Helsinki (FI)**

(72) Inventor: **Paajanen, Risto Johannes, Torikatu 5 C 25, F-11100 Filhimäki (FI)**

(74) Representative: **Rostovanyi, Peter et al, AWAPATENT AB Box 5117, S-200 71 Malmö (SE)**

(54) A method for measuring of capacities, particular low ones.

(57) A method for measuring capacitances using a measuring oscillator (10), whose cycle time is proportional to measured capacity ($C_M$) and reference capacities ($C_{R1}$, $C_{R2}$) to be alternately connected to the input terminals (a, b) of a circuit that determines its frequency (f). The output of measuring oscillator (10) is connected to at least two cascade-connected dividers (11, 12); in the first one of these dividers (11) the oscillator frequency (f) is divided with one number (n) and in the second divider the once divided frequency of the oscillator (f/n) is further divided with another number (m). The frequency (f/n) divided with the first number (n) controls a logic unit (14), which controls switches (13a, 13b, 13c) that alternately and by pairs connect said capacities ($C_M$, $C_{R1}$, $C_{R2}$) to the measuring oscillator (10). Control pulse trains are directed from switches (13a, 13b, 13c) switching capacities ($C_M$, $C_{R1}$, $C_{R2}$) to the logic unit to inverters (15a, 15b, 15c), which are one by one connected to analog switches (16a, 16b, 16c, 16d) controlled by the output of the second divider. The outputs of analog switches (16a, 16b, 16c, 16d) are each connected to separate RC filters (17a, 17b, 17c, 17d), whose time constants ($\tau = R \times C$) have been fixed on such a high level that said RC filters also act as a holding circuit when no pulses are let to them by the analog switches (16a, 16b, 16c, and 16d). From the outputs of said RC filters it is formed a signal, which contains the information about the measured capacity ($C_M$), and a feedback signal (f), by which the operational voltage of said inverters (15a, 15b, 15c) is adjusted in such a way that at the same time the amplitudes of the pulse trains leaving said inverters (15a, 15b, 15c) are correspondingly changed.

The present invention relates to a method for measuring capacities, particularly low ones, in which method such a measuring oscillator is used whose output frequency is a function of the capacity that is connected to the input terminals of a circuit that determines the frequency of said oscillator, and in which method such known reference cacitities are used that are alternately connected, together with the capacity or capacities to be measured, to a measuring oscillator, using a switch arrangement.

One basis for the present invention has been the state of art that is described in the Applicant's Finnish patents 54 664 and 57 319 (equivalent US patents 4 295 090 and 4 295 091). These patents describe a method for measuring low capacities and an electronic change-over switch particularly for telemetrical use in radiosondes.

Capacitive sensors, whose capacity depends on the parameter to be measured, are used in radiosondes for measuring various parameters, particularly pressure, temperature, and humidity. The capacities of these sensors are often rather low, from a few picofarades to some twenty, thirty or fourty, or at the most approx. a hundred picofarades. Measuring low capacities is problematic due to, among other things, stray capacities, variations of input voltage, and other interferences. These sensors are also individual to some extent; for instance, their non-linearity and temperature dependence are individual.

In the prior art, when measuring temperature, humidity, pressure, or other similar quantities with electrical or electromechanical sensors, one or more exactly known references are installed in association with the measuring electronics, so that inaccuracies of the measuring circuit and/or sensor can be compensated.

In the prior art, a reference capacity is used in association with capacitive sensors. This reference capacity is connected alternately with the measured capacity to the input circuit that determines the frequency of the measuring circuit, usually an RC oscillator. By suitably adjusting the measuring circuit, or in some other way, the output quantity of the measuring circuit, represented by the reference capacity, may be set to a correct level.

A known method is to use one-reference measuring circuits, particularly bridge connections. In these methods the measurement is accurate only if the electrical value of the refererence is close to the value of the sensor, for instance when the bridge is in balance. The larger is the deviation between the sensor value and the reference, the larger are various errors, for instance errors due to variations in the dynamics of the electronic measuring circuit. An advantage of one-reference wirings is however the simplicity of the measuring circuit.

An advatage of two-reference or multi-reference measuring arrangements is the accuracy of measurement over a large measuring range; a drawback is the complexity of structure and calculation.

An object of the present invention is to further develop known methods and circuits developed by the Applicant for measuring low, for instance approx. 0 - 100 pF, capacities, so that these methods and circuits will be even more accurate.

An additional object of the invention is to provide such a measuring circuit, in which the effects of connecting phenomena can be eliminated.

An additional, not essential object of the invention is to provide such a measuring circuit and method in which the output quantity is a suitably linearized, compensated, and scaled direct voltage, and which measuring circuit and method may when required be supplemented with a simple temperature compensation.

For attaining the objectives mentioned above and to be expressed later, the principal charasteristic features of the invention are

that the method makes use of such a measuring oscillator, whose signal cycle time is directly proportional to the measured capacity and to the reference capacities, which are alternately connected to input terminals of the circuit that determines the frequency of the oscillator, and that there are two different reference capacities,

that the output of said measuring oscillator is connected to at least two cascade-connected dividers, and that in the first divider the oscillator frequency is divided by one number, and in the second divider the oscillator frequency, already divided in the first divider, is divided again by another number,

that the frequency divided by the first number controls a logic unit that controls the switches connecting said capacities alternately by pairs to the measuring oscillator in such a way that the first reference capacity and the measured capacity are connected in turns at intervals whose length is one half-cycle of first pulse train determined by said dividing ratio, and

that the pulse train of the second divider controls said logic unit in such a way that, at intervals of one half-cycle of the last-mentioned pulse train, the measured capacity is alternated with the second reference capacity, which is to be alternated with the first reference capacity at intervals determined by the half-cycle of the first pulse train.

The invention makes use of two cascade-connected dividers. The first one of them produces a pulse train that controls the logic unit. The length of the half-cycle of this first pulse train determines the connecting and alternating intervals of the capacities to be alternated. At intervals determined by the half-cycle of the pulse train produced by the second divider, controlled by said logic unit, the measured capacity is replaced with the second reference capacity and vice versa, after which the reference capacities are alternated at intervals determined by the first pulse train. This is the way to implement a two-reference wiring, in other words to determine both the slope and the offset of the calibrating line.

The invention will now be described in detail, with reference to an embodiment of the invention shown in the figures of the accompanying drawing, with no intention to restrict the invention to these details.

Figure 1 is a block diagram of an embodiment of the method in accordance with the invention.

Figure 2 illustrates the pulse trains produced by the first and the second dividers of the circuit illustrated in figures 1 and 3.

Figure 3 is a block diagram of another embodiment of the method in accordance with the invention.

Figure 4 is an alternative arrangement for producing the feedback voltage of the circuit shown in figure 3.

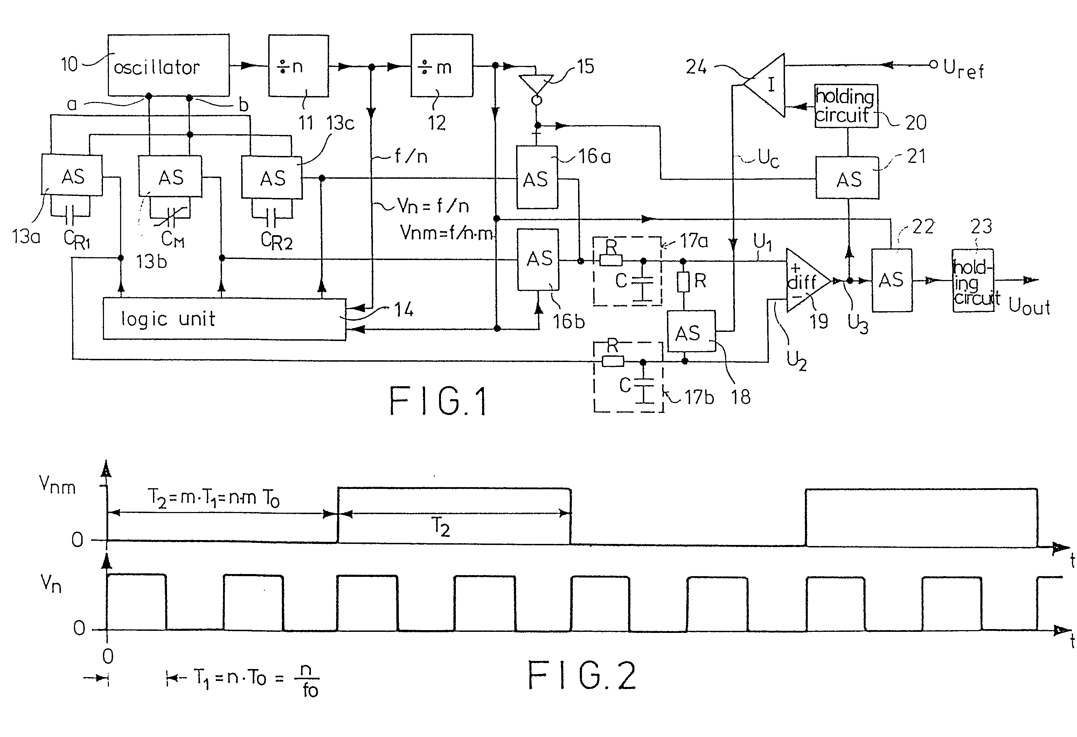

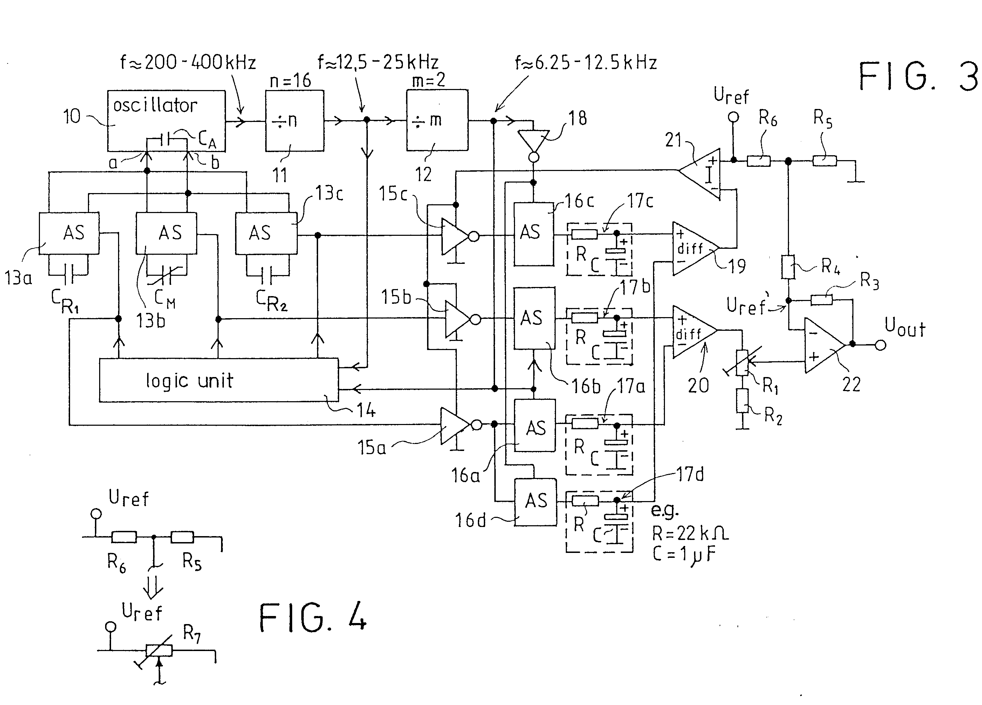

In the wiring illustrated in figures 1 and 3 there is for instance an RC oscillator 10; time $T_0$ of the output cycle of this oscillator is directly proportional – thence frequency $1/T_0$ inversely proportional – to capacity $C_M$, $C_{R1}$, or $C_{R2}$, which is connected to input terminals a and b of the circuit that determines the frequency of oscillator 10.

In accordance with the invention, pairs consisting of sensor capacity $C_M$ and one of reference capacities $C_{R1}$ and $C_{R2}$, of which $C_{R1}$ is lower than $C_M$ and $C_{R2}$ higher than $C_M$, are by turns connected to input a, b of oscillator 10. Said capacities are connected to oscillator 10 by means of semiconductor switches AS (13a, 13b, and 13e), which are controlled by logic unit 14. Switches AS are for instance so called analog switches, therefore components that are commercially available.

Logic unit 14 is controlled by pulses, which are created by dividing frequency f of oscillator 10 by a certain first number n and further by a certain second number m, numbers n and b being preferably integers. Blocks 11 and 12 represent the cascade-connected units which carry out divisions shown in the figure. Pulse train $V_n = f/n$, which is divided by n from the pulse train of oscillator 10, is taken to logic unit 14, which controls switches 13a, 13b, and 13c of capacities $C_M$, $C_{R1}$, and $C_{R2}$, which switches alternate by pairs capacities $C_{R1}$ and $C_M$ which each other or capacities $C_{R1}$ and $C_{R2}$ with each other. Whether it is capacity $C_M$ or $C_{R2}$ that is alternated with $C_{R1}$, is determined by the state of pulse train $V_{nm} = f/n \cdot m$ that is divided from pulse trains f by n and m (figure 2). In the figure 2, the half-cycle of pulse train $V_{nm}$ is indicated by $T_2$.

As cycle time T of oscillator 10 is proportional to capacity $C_M$, $C_{R1}$, $C_{R2}$ connected to oscillator 10, and because said capacities are replaced by each other at the beginning of every half-cycle $T_1$ (fig. 2) of the pulse of pulse train f/n divided by number n of the pulse chain of the oscillator, also length of half-cycle $T\&_1$ is directly proportional to the capacity connected to oscillator 10 during the same half-cycle $T_1$.

When comparing (alternating) $C_{R1}$ and $C_M$ with each other, the control pulse train whose pulse ratio changes as $C_M$ changes ($C_{R1}$ is constant), is obtained from switch 13b switching $C_M$. Control pulse train of switch 13a switching $C_{R1}$ is then opposite in direction compared with control pulse train of switch 13b of $C_M$.

As shown in figure 1, as the pulse of pulse train $V_{nm}$ divided from the pulse train of oscillator 10 by m and n is for instance down, switches 16b and 22 are in the conducting state. Control pulse trains of switches 13a and 13b switching $C_{R1}$ and $C_M$ are now allowed to proceed to RC filters 17a and 17b. In the manner known as such, filters 17a and 17b act as low pass filters (integrators), when $RC >> T_1$. This creates two voltages $U_1$ and $U_2$, whose difference is conducted to the differential amplifier 19, whose output voltage $U_3$ indicates the difference of $C_M$ and $C_{R1}$. Ouput voltage $U_3$ is measured against ground.

The one-reference wiring has noe been carried out in accordance with figure 1, in other words, we have defined the system calibration line y = kx - b, which runs through point (0, b) defined as described above (offset = b). For also determining and locking the slope k of this calibration line, another point $(x_0, y_0)$ of the line is still to be determined. Therefore, in a wiring in accordance with the invention, we use another known reference capacity $C_{R2}$ represented by a known point of x-axis and another known voltage represented by a known point of y-axis. By adjusting said slope k, the line can be made - in spite of thermal drifts of the measuring electronics - run via said point $(x_0, y_0)$. The slope is stabilized in the following manner: as the pulse of pulse train $V_{nm}$ obtained by dividing pulse train of oscillator 10 by both m and n, i.e. with nm, is up, capacities $C_{R1}$ and $C_{R2}$ are alternated. In that case switches 16b and 22 are open (non-conducting) and switches 16a and 21 closed (conducting). When the pulse trains controlling switches 13a and 13c are now taken to RC filters 17a and 17b, the output of differential amplifier 19 will have voltage $U_1 - U_2$, which manifests the difference of reference capacities $C_{R2}$ and $0C_{R1}$. In order to maintain this voltage $U_1 - U_2$ stabile in spite of temperature or other interferences, it is taken via switch 21 and holding circuit 20 to an integrating comparator 24, to which also an outer reference voltage $U_{ref}$ is taken. The output voltage U c of comparator 24 is taken to a linear-range analog switch 18, located in the amplifying train, whose resistance can thus be varied, and consequently adjust the amplification of the circuit by varying the operating voltage of the logic unit, amplification of the differential amplifier, or as shown in the figure, load of RC filter 17a, or another similar parameter. The amplification of the system is therefore adjusted in such a way that when varying capacities $C_{R1}$ and $C_{R2}$, differential amplifier 19 has output voltage $U_3 = U_{ref}$.

In the wiring of figure 1, as capacities $C_{R1}$ and $C_{R2}$ are varied, analog switches 16a and 21 are open (non-conducting). Now holding circuit 20 between switch 21 and integrating comparator 24 holds the amplification constant a measuring result is obtained via switch 22 to the holding circuit 23 located in the output. Holding circuit 23 holds the output voltage constant as the analog switch 22 is open (non-conducting).

As now $C_{R2} - C_{R1}$     $U_{ref}$,

$$U_{out} = \frac{C_M - C_{R1}}{C_{R2} - C_{R1}} \cdot U_{ref}$$

As seen from the equation above, wiring of figure 1 produces voltage $U_{out}$ (direct voltage), which depends on the capacity $C_M$ to be measured in a way that can be determined by setting the reference capacity $C_{R1}$ and $C_{R2}$ in a suitable manner.

The created output voltage will advantageously be a direct voltage, which can, by adjusting voltage $U_{ref}$, be suitably scaled.

An exemplary embodiment of the invention is such an measuring circuit, shown in fig. 1, where

$$C_{R1} = 40 \text{ pF}$$

$$C_{R2} = 60 \text{ pF}$$

$$C_M = 45 \text{ pF} - 55 \text{ pF}$$

$$f = 500 \text{ kHz}$$

$$n = 16$$

$$m = 256$$

$$RC = 0,5 \text{ ms}$$

$$U_{ref} \quad 2 \text{ V}$$

$$U_{out} = 0,5 - 1,5 \text{ V}$$

Figure 3 illustrates the most advantageous embodiment by now. This embodiment differs fabourably from the wiring illustrated in figure 1 particularly for the part of circuits following the logic unit and the holding elements in the wiring. In a solution shown in fig 1, one must use several holding elements in such locations where their use is not always compeletely non-problematic.

In the wiring of figure 1, analog switches 16a and 16b alternately count pulse trains of RC filter 17a, the pulse trains having different pulse ratios. Two different pulse trains are also driven to the RC filter of the wiring of figure 1. The voltage of said RC filter does not, due to its time constant, immediately change to its correct value as the pulse train changes.

The following is a description of the structure and operation of the wiring illustrated in figure 3 as concerns the deviations from figure 1.

The control pulse trains are conducted from switches 13a, 13b, and 13c of figure 3 to inverters 15a, 15b, and 15c of the logic unit. Inverters 15a, 15b, and 15c receive their adjustable operating voltage from comparator 21. As the operating voltage of inverters 15a, 15b, and 15c is adjusted, the amplitude of the pulse trains that leave them is also changed.

In figure 3, as oscillator 10 measures (compares) $C_{R1}$ and $C_{R1}$, the output of inverter 15c transmits a pulse, which is allowed to proceed via analog switch 16c to RC filter 17c. Simultaneously a pulse of the opposite phase as compared with the output of 15c is received from inverter 15a. This is allowed to proceed through analog switch 16d to RC filter 17d. The length of the positive half-cycle of the pulse going to RC filter 16d is directly proportional to capacity $C_{R2}$, and the negative half-cycle is proportional to capacity $C_{R1}$. Therefore a higher voltage is obtained from RC filter 17c than from RC filter 17d that filters an opposite-phased pulse. The difference of these voltages corresponds to and includes information about the difference between capacities $C_{R2}$ and $C_{R1}$. This voltage difference is amplified with the differential amplifier 19 to the level of reference voltage $U_{ref}$. Should the temperature or some other interference change this voltage difference, integrating (I) comparator adjusts the operating voltage of inverters 15a, 15b, and 15c in such a way that voltage $U_{ref}$ is again obtained from differential amplifier 19, as, when adjusting the amplitude of the pulse trains, also voltages filtered from the opposite-phased pulse trains are adjusted and consequently the difference of these opposite-phased pulse trains is adjusted.

In figure 3, also output voltages of RC filters 17b and 17a are adjusted to the correct level in the following measurement of $C_M$ $C_{R1}$. As oscillator 10 measures $C_{R1}$ and $C_M$ ($C_M \geq C_{R1}$), inverter 15b transmits a pulse whose positive half-cycle corresponds to $C_M$ and negative half-cycle to $C_{R1}$. Now the pulse of inverter 15a is opposite-phased as to pulse 15b. The pulse given by inverter 15b is allowed to proceed through analog switch 16b to RC filter 17b, and the pulse given by inverter 15a is allowed to proceed via analog switch 16a to RC filter 17a. The difference of voltages transmitted by RC filters 17b and 17a now corresponds to the difference of capacities $C_M$ and $C_{R1}$.

The essential feature of figure 3 as compared with figure 1 is that time constants of RC filters 17a, 17b, 17c, and 17d have been fixed on such a high level that said RC filters also act as a holding circuit when no pulses are let to them by analog switches 16a, 16b, 16c, and 16d. An example of the dimensioning of the RC circuit is: R = 22 k$\Omega$ , C = µF. Thus the time constant the RC circuit is $\tau$ = R x C = 22 ms. Usually  is 5 to 100 ms. When comparing $C_{R2}$ and $C_{R1}$ analog switches 16c and 16d are conducting and analog switches 16b and 16c non-conducting. When comparing $C_M$ and $C_{R1}$ analog switches 16b and 16a are conducting and analog switches 16c and 16d non-conducting.  The difference of voltages from RC filters 17b and 17a, which corresponds to difference between $C_M$ and $C_{R1}$, is amplified with differential amplifier 20.

In figure 3, if amplifications of differential amplifiers 19 and 20 are set equal, so, when for instance $C_{R1}$ is for instance 42 pF, $C_{R2}$ is 56 pF, the dry capacity of the Applicant's Humicap® sensor is 45 pF, 0% relative humidity corresponds to the output voltage $U_{out}$ = 0,214 x $U_{ref}$ of differential amplifier 20, whereupon at 100% relative humidity output voltage would respecitively be $U_{out}$ = 0,889 x $U_{ref}$.  This output voltage range can be scaled as required for instance with $R_1$ (adjustement of gain) and with trimmer potentiometer $R_7$ (adjustment of offset) substituting for $R_6$ and $R_5$ as illustrated in figure 4.

In the embodiment of figure 3 materializes the one-point calibration described above and illustrated in figure 1, where $C_{R1}$ is zero and a base capacity $C_A$ is connected to oscillator 10.  The base capacity $C_A$ determines the top frequency of the oscillator, which with for instance CMOS technology is $f_y$ $\approx$  500 to 600 kHz. Thus the operating frrequency range is usually 200 to 600 kHz.  Now a voltage directly proportional to the measured capacity $C_M$ is created to the output of differential amplifier 20.

In the one-point calibration described above the reference voltage correspnding to the dry capacity of the sensor, which in the wiring of figure 3 is $U_{ref}'$, is obtained from voltage $U_{ref}$ of figure 3 by means of resistors $R_5$ and $R_6$.  It is substracted from the voltage obtained from the slide of $R_1$ by feeding for instance a reference voltage corresponding to said dry capacity to the inverting input of the operational amplifier 22 via resistor $R_4$.

The amplification of amplifier 22 is $[R_3/R_4 + (R_6/R_5)] + 1$

The voltage, obtained from the slide of $R_1$, corresponding to the total capacity of the Humicap® sensor, is adjusted with $R_1$ in such a way that the voltage corresponding to the dry capacity of the Humicap® sensor equals to $U_{ref}'$.

$$U_{ref'} = \frac{R_3}{R_4 + R_3 + \dfrac{R_6 \times (R_5 + R_4 + R_3)}{R_5}} \times U_{ref}$$

when output voltage $U_{out} = 0$ (see figure 3).

Compared with the wiring of figure 1, figure 3 has two more RC filters, to which the pulse trains are conducted when measuring the upper reference capacity. In this way the time constants of the RC filters can be selected so high that RC filters also work as a holding circuit. Thus no separate holding circuits are required in the analog section of the circuit. Integrating analog circuits onto silicon is not difficult as such, but if the analog switches are located in the analog section, extra pins must be reserved for them in the circuit, which increases the size of the case of the microcircuit and consequently its price. It is however necessary to use to differential stages in the wiring; one of them controls the integrating comparator, the other one gives for instance voltage that is proportional to the capacity of the Applicant's Humicap® sensor. In the wiring of figure 1, the output voltage of teh integrating comparator is used as the operating voltage of the inverters of the logic unit; by correcting this operating voltage the output voltage of the differential amplifier is locked to the same level as the system reference voltagge $U_{ref}$. At the same time the output voltage of said differential amplifier is set to the right range.

The invention is by no means restricted to aforementioned details which are described only as exampls; they may vary within the framewirk of the inventional idea as defined in the following claims.

Claims

1. A method for measuring capacities, particularly low ones, in which method such a measuring oscillator (10) is used whose output frequency (f) is a function of the capacity that is connected to the input terminals (a,b) of a circuit that determines the frequency of said oscillator, and in which method such known reference cacities are used that are alternately connected, together with the capacity ($C_M$) or capacities to be measured, to a measuring oscillator, using a switch arrangement, wherein

the method makes use of such a measuring oscillator (10), whose signal cycle time ($T_0$) is directly proportional to the measured capacity ($C_M$) and to the reference capacities ($C_{R1}$ and $C_{R2}$), which are alternately connected to input terminals (a,b) of the circuit that determines the frequency (f) of the oscillator (10), and that there are two different reference capacities,

the output of said measuring oscillator (10) is connected to at least two cascade-connected dividers (11, 12), and that in the first divider (11) the oscillator frequency (f) is divided by one number (n), and in the second divider (12) the oscillator frequency (f/n), already divided in the first divider, is divided again by another number (m),

the frequency (f/n) divided by the first number (n) controls a logic unit (14) that controls the switches (13a, 13b, 13c) connecting said capacities ($C_M$, $C_{R1}$, $C_{R2}$) alternately by pairs to the measuring oscillator (10) in such a way that the first reference capacity ($C_{R1}$) and the measured capacity ($C_M$) are connected in turns at intervals whose length is one half-cycle ($T_1 = n \cdot T_0$) of first pulse train ($V_n$) determined by said dividing ratio (n), and

0166705

the pulse train ($V_{nm}$) of the second divider (12) controls said logic unit (14) in such a way that, at intervals of one half-cycle ($T_2 = m \cdot T_1 = n \cdot m \cdot T_0$) of the last-mentioned pulse train, the measured capacity ($C_M$) is alternated with the second reference capacity ($C_{R2}$), which is to be alternated with the first reference capacity ($C_{R1}$) at intervals determined by the half-cycle ($T_1$) of the first pulse train ($V_n$).

2. A method in accordance with claim 1, wherein a control pulse train, whose pulse ratio variations are used as a measure of the measured capacity ($C_M$), is taken from the switch (13a) switching the measured capacity ($C_M$).

3. A method in accordance with claim 1 or 2, wherein

control pulse trains are directed from switches (13a, 13b, 13c) switching said capacities ($C_M$, $C_{R1}$, $C_{R2}$) to the logic unit to the inverters (15a, 15b, 15c).

each of said inverters (15a, 15b, 15c) are connected to analog switches (16a, 16b, 16c, 16d),

said analog switches (16a, 16b, 16c, 16c) are controlled by the output of said second divider (12),

the outputs of said analog switches (16a, 16b, 16c, 16d) are connected each to a separate RC filter (17a, 17b, 17c, 17d),

the time constants ($\tau$ = R x C) of the RC filters (17a, 17b, 17c, and 17d) have been fixed on such a high level that said RC filters also act as a holding circuit when no pulses are let to them by the analog switches (16a, 16b, 16c, and 16d).

from the outputs of said RC filters it is formed an amplified signal, which contains the information about the measured capacity ($C_M$), and a feedback signal (f), by which the operational voltage of said inverters (15a, 15b, 15c) is adjusted in such a way that at the same time the amplitudes of the pulse trains leaving said inverters (15a, 15b, 15c) are correspondingly changed (figure 3).

4. A method in accordance with claim 3, wherein the time constants ($\tau$ =R x C) of said RC filters are of the order of 5 to 100 ms, preferably 10 to 50 ms, in such a way that the RC filters function as holding circuits as defined above (figure 3).

5. A method in accordance with claim 1, wherein the control pulse trains received from the switches (13a, 13c) switching the reference capacities ($C_{R1}$, $C_{R2}$) are both connected via separate inverter – analog switch – RC filter combinations (15a, 16d, 17d; 15c, 16c, 17c) to a differential amplifier (19), whose input then has a voltage difference, which contains information about the difference of reference capacities ($C_{R1}$, $C_{R2}$), wherein the output signal of said differential switch (19) is used as a feedback signal (f) that is connected to an integrating comparator (21), whose other terminal has the reference voltage ($U_{ref}$), wherein the adjusting arrangement defined above is set to operate in such a way that the output voltage of said differential amplifier (19) is adjusted to be the equal of the reference voltage ($U_{ref}$), and wherein, in the manner described above, the output voltages of said RC filters (17a, 17b) are adjusted to correct levels for the next phase of the method, i.e. the measurement (comparation) of the measured capacity ($C_M$) and the first reference capacity ($C_{R1}$) (figure 3).

6. A method in accordance with one of claims 3 to 5, wherein, when measuring and comparing the measured capacity ($C_M$) and the first reference capacity ($C_{R1}$) that is lower than the measured capacity ($C_M >$ $C_{R1}$), the control pulse trains are directed from analog switches (13a, 13b) switching said capacities ($C_M$, $C_{R1}$) via inverter – analog switch – RC filter combinations (15a, 16a, 17a; 15b, 16b, 17b) to the differential amplifier (20), whose input voltage will be the voltage

16

0166705

difference, which contains information about the difference of the measured capacity and the first reference capacity ($C_M - C_{R1}$), and **wherein** the output of said differential amplifier gives such a signal which contains information about the measured capacity ($C_M$).

7. A method in accordance with one of claims 3 to 6, wherein the logic unit in accordance with the invention comprises four analog switches (16a, 16b, 16c, and 16d, of which, at the moment when the reference capacities ($C_{R1}$, $C_{R2}$) are compared with each other, two analog switches (16c, 16d) are conducting and the other two (16c, 16d) are non-conducting.

8. A method in accordance with one of claims 3 to 7, wherein the lower reference capacity ($C_{R1}$) is essentially the equal of zero, so that this capacity will be represented only by stray capacities of its connecting wires, wherein a base capacity ($C_A$) determining the top frequency of oscillator (10) is connected to the oscillator, and wherein, by means of the arrangement described above, a voltage directly proportional to the measured capacity ($C_M$) is obtained to the output of the differential amplifier (20).

9. A method in accordance with claim 8, wherein, in one-point calibration, the reference voltage ($U_{ref}'$) corresponding to the dry capacity of the sensor is obtained from the reference voltage by means of a voltage division wiring ($R_5$, $R_6$).

10. A method in accordance with claim 9, wherein the voltage obtained by said voltage division ($R_5$, $R_6$) is subtracted from the voltage obtained from the slide or similar of the potentiometer ($R_1$, $R_2$) connected to the output of the differential amplifier by feeding a reference voltage ($U_{ref}'$) corresponding to said dry capacity to the inverting input of the operational amplifier (22) of the feedback circuit by means of a resistor wiring.

0166705

11. A method in accordance with claim 1 or 2, wherein the switches (16b and 22) belonging to the measuring circuit which have been arranged so as to be controlled by the pulse train $(V_{nm})$ obtained from the second divider (12) in such a way that when the last-mentioned pulse is for instance down, said switches (16b and 22) are in the conducting state (closed), and now the control pulse trains of the switches (13a, 13b) switching the first reference capacity $(C_{R1})$ and the measured capacity $(C_M)$ are directed to pass to the RC low pass filters (17a and 17b) belonging to the measuring circuit, which low pass filters produce two voltages $(U_1$ and $U_2)$ (figure 1).

12. A method in accordance with claim 11, wherein two voltages $(U_1, U_2)$ obtained from said RC filters (17a, 17b) are directed to the differential amplifier (19), which, at its output, has the voltage $(U_3)$ that indicates the difference of the measured capacity $C_M$ and the first reference capacity $C_{R1}$ in such a way that the offset (b) of the system calibration line has been determined (figure 1).

13. The use of a method in accordance with one of claims 1 to 12 in radiosondes or similar for telemetrical measurement of air pressure, temperature and/or humidity.

FIG.1

FIG.2

FIG. 3

FIG. 4